# EUROPEAN PATENT APPLICATION

(11) **EP 4 600 744 A1**
(43) Date of publication of application: **13.08.2025**
(21) Application number: 23874714.1
(22) Date of filing: 26.09.2023
(51) Int. Cl.: G03F 7/075, C09K 11/08, G02B 5/20, G03F 7/004, G03F 7/027, G03F 7/20

(54) **PHOTOSENSITIVE RESIN COMPOSITION, PHOTOSENSITIVE RESIN COATING FILM, PATTERN FORMATION METHOD, AND LIGHT-EMITTING ELEMENT**

(30) Priority: 05.10.2022 JP 2022160787
(71) Applicant: SHIN-ETSU CHEMICAL CO., LTD., Tokyo 1000005 (JP)
(72) Inventor: MARUYAMA, Hitoshi, Annaka-shi, Gunma 379-0224 (JP); AOKI, Shinji, Annaka-shi, Gunma 379-0195 (JP); NOJIMA, Yoshihiro, Annaka-shi, Gunma 379-0195 (JP); TOBISHIMA, Kazuya, Annaka-shi, Gunma 379-0195 (JP)
(74) Representative: Schicker, Silvia
(86) International application number: PCT/JP2023/034849
(87) International publication number: WO 2024/075586

(57) **Abstract**

The present invention is a photosensitive resin composition including: (A) a (meth)acryloyl group-containing resin; (B) a photo-radical generator; and (C) a quantum dot, wherein the quantum dot has a surface coating layer containing siloxane. This can provide: a photosensitive resin composition capable of easily forming a film having high lithography resolution and favorable luminous properties; a photosensitive resin film obtained by using the photosensitive resin composition; patterning processes using these; and a light emitting device obtained by using the photosensitive resin composition.

## Description

### TECHNICAL FIELD

The present invention relates to: a photosensitive resin composition, a photosensitive resin film which utilize the photosensitive resin composition, a patterning process, and a light emitting device.

### BACKGROUND ART

Various methods have been proposed to form displays containing red, green, and blue subpixels. As one of the methods, there is a method in which light from an LED array is converted through a color conversion structure such that blue light having a shorter wavelength is converted to red and green light having longer wavelengths. Quantum dots have been employed for this color conversion.

Recently, such LED arrays are fabricated in micro size, and micro-LED displays using these have drawn attention. Although a method of forming a color conversion structure on an LED array includes a lithography process using a photosensitive material (Patent Document 1), further miniaturization has been demanded recently to use for a small display. In addition, there are high demands for luminous properties from the viewpoint of display clearness.

### CITATION LIST

### PATENT LITERATURE

Patent Document 1: JP 2021-089347 A

### SUMMARY OF INVENTION

### TECHNICAL PROBLEM

The present invention has been made in view of the above circumstances. An object of the present invention is to provide: a photosensitive resin composition capable of easily forming a film having high lithography resolution and favorable luminous properties; a photosensitive resin film obtained by using the photosensitive resin composition; patterning processes using these; and a light emitting device obtained by using the photosensitive resin composition.

### SOLUTION TO PROBLEM

To solve the above problems, the present invention provides a photosensitive resin composition comprising:
(A) a (meth)acryloyl group-containing resin;
(B) a photo-radical generator; and
(C) a quantum dot, wherein
the quantum dot has a surface coating layer containing siloxane.

Such a photosensitive resin composition can easily form a film having high lithography resolution and favorable luminous properties.

Further, in the present invention, the component (C) preferably has a skeleton having a (meth)acryloyl group in the surface coating layer.

Such a photosensitive resin composition can prevent the quantum dot from escaping in developing and can impart high luminous properties to a pattern.

Further, in the present invention, the quantum dot as the component (C) preferably has a ligand coordinated on the surface, the surface coating layer preferably has a siloxane bond bonded to the ligand, and a substituent of the ligand preferably has any one or more kinds of an amino group, a thiol group, a carboxy group, a phosphino group, a phosphine oxide group, or an ammonium ion.

The quantum dot having such a ligand easily coordinates to the surface and thus is preferable.

Further, in the present invention, the component (C) is preferably contained in 5 to 80 mass% of the photosensitive resin composition.

Such a photosensitive resin composition can form a fine pattern while keeping favorable luminous properties.

Further, in the present invention, the component (A) preferably has a double bond equivalent of 240 to 1,000 g/mol.

Such a photosensitive resin composition has high crosslinking density and can form a pattern with a good shape after development.

Further, in the present invention, the component (A) preferably has a weight-average molecular weight of 5,000 to 100,000 g/mol.

Such a photosensitive resin composition makes it difficult to cause a decrease in a film quantity of an exposed portion when developed and has a good solubility of an unexposed portion.

Further, in the present invention, the photosensitive resin composition preferably further comprises (D) a surfactant.

Such a photosensitive resin composition can improve coatability.

Further, in the present invention, the photosensitive resin composition preferably further comprises (E) a silane coupling agent.

Such a photosensitive resin composition can improve adhesiveness to a substrate.

Further, in the present invention, the photosensitive resin composition preferably further comprises a crosslinking agent (F) having 2 or more functions of (meth)acryloyl groups.

By using such a photosensitive resin composition, the obtained cured film has high reliability.

Further, in the present invention, the photosensitive resin composition preferably further comprises (G) a solvent.

Such a photosensitive resin composition can improve coatability.

Further, the present invention provides a photosensitive resin film comprising a dried product of the photosensitive resin composition described above.

Such a photosensitive resin film has a high lithography resolution and favorable luminous properties.

Further, the present invention provides a patterning process comprising steps of:
(i) applying the photosensitive resin composition described above onto a substrate to form a photosensitive resin film on the substrate;
(ii) exposing the photosensitive resin film to light; and
(iii) developing the exposed photosensitive resin film with a developer to dissolve and remove an unexposed portion, thereby to form a pattern.

By such a patterning process, it is possible to form a pattern with high lithography resolution and obtain a pattern of a film having favorable luminous properties.

Further, the present invention provides a light emitting device comprising a cured film obtained by the patterning process described above.

Such a light emitting device has high lithography resolution and favorable luminous properties.

### ADVANTAGEOUS EFFECTS OF INVENTION

The inventive photosensitive resin composition can easily form a film having high resolution and favorable luminous properties thanks to containing a resin having a (meth)acryloyl group, a photo-radical generator, and a quantum dot having a specific surface coating layer, and therefore is suitable for a light emitting device.

### DESCRIPTION OF EMBODIMENTS

As described above, it has been desired to develop a photosensitive resin composition capable of easily forming a film having high lithography resolution and favorable luminous properties; a photosensitive resin film obtained by using the photosensitive resin composition; patterning processes using these; and a light emitting device obtained by using the photosensitive resin composition.

As a result of their diligent study to achieve the above purpose, the inventor(s) found that a photosensitive resin composition containing (A) a (meth)acryloyl group-containing resin, (B) a photo-radical generator, and (C) a quantum dot, which had a surface coating layer containing siloxane, could easily form a film (photosensitive resin film) having high lithography resolution and favorable luminous properties, and have completed the present invention.

That is, the present invention is a photosensitive resin composition comprising:
(A) a (meth)acryloyl group-containing resin;
(B) a photo-radical generator; and
(C) a quantum dot, wherein
the quantum dot has a surface coating layer containing siloxane.

Hereinafter, the present invention will be described in detail, but the present invention is not limited thereto.

### [Photosensitive Resin Composition]

The inventive photosensitive resin composition contains (A) a (meth)acryloyl group-containing resin, (B) a photo-radical generator, and (C) a quantum dot having a specific surface coating layer. As necessary, the inventive photosensitive resin composition may further contain other components, such as (D) a surfactant, (E) a silane coupling agent, (F) a crosslinking agent having 2 or more functions of (meth)acryloyl groups, and (G) a solvent. Hereinbelow, each component constituting the photosensitive resin composition will be described.

### [(A) (Meth)acryloyl Group-Containing Resin]

The (meth)acryloyl group-containing resin (A) to be used in the present invention is not particularly limited as long as it has a (meth)acryloyl group.

In the present invention, the (meth)acryloyl group-containing resin (A) preferably has a weight-average molecular weight in the range of 5,000 to 100,000 g/mol, more preferably in the range of 10,000 to 50,000 g/mol. When the weight-average molecular weight of the (meth)acryloyl group-containing resin (A) is within the above range, it difficult to cause a decrease in a film quantity of an exposed portion when developed and has a good solubility of an unexposed portion. The weight-average molecular weight is a value determined as a weight-average molecular weight (weight-average degree of polymerization) in terms of polystyrene according to gel permeation chromatography (GPC) using toluene as a developing solvent.

In the present invention, the (meth)acryloyl group-containing resin (A) preferably has a double bond equivalent in the range of 240 to 1,000 g/mol, more preferably in the range of 240 to 700 g/mol. The double bond equivalent is the weight of the resin per acrylic group. When the double bond equivalent of the (meth)acryloyl group-containing resin (A) is within the above range, it is possible to form a pattern with high crosslinking density and a good shape after development.

In the present invention, the (meth)acryloyl group-containing resin (A) preferably has an acid value in the range of 0 to 150 mgKOH/g. When the acid value is less than 30 mgKOH/g, the solubility in an alkaline developer is low, making development with an organic solvent suitable. When the acid value is 150 mgKOH/g or less, the pattern will not peel off during alkaline development.

In the present invention, one of the (meth)acryloyl group-containing resins (A) may be used, or two or more kinds thereof may be used in combination. The (meth)acryloyl group-containing resin (A) is preferably in the range of 10 to 90 mass%, more preferably in the range of 15 to 85 mass% relative to the total amount of the photosensitive resin composition.

### [(B) Photo-Radical Generator]

The photo-radical generator used in the present invention is not particularly limited. Examples thereof include acetophenone compounds, benzophenone compounds, thioxanthone compounds, benzoin compounds, triazine compounds, and oxime compounds.

Examples of acetophenone compounds include 2,2'-diethoxyacetophenone, 2,2'-dibutoxyacetophenone, 2-hydroxy-2-methylpropiophenone, p-t-butyltrichloroacetophenone, p-t-butyldichloroacetophenone, 4-chloroacetophenone, 2,2'-dichloro-4-phenoxyacetophenone, 2-methyl-1-(4-(methylthio)phenyl)-2-morpholinopropan-1-one, and 2-benzyl-2-dimethylamino-1-(4-morpholinophenyl)-butan-1-one.

Examples of benzophenone compounds include benzophenone, benzoylbenzoic acid, methyl benzoylbenzoate, 4-phenylbenzophenone, hydroxybenzophenone, acrylated benzophenone, 4,4'-bis(dimethylamino)benzophenone, 4,4'-bis(diethylamino)benzophenone, 4,4'-dimethylaminobenzophenone, 4,4'-dichlorobenzophenone, and 3,3'-dimethyl-2-methoxybenzophenone.

Examples of the thioxanthone compounds include thioxanthone, 2-methylthioxanthone, isopropylthioxanthone, 2,4-diethylthioxanthone, 2,4-diisopropylthioxanthone, and 2-chlorothioxanthone.

Examples of the benzoin compounds include benzoin, benzoin methyl ether, benzoin ethyl ether, benzoin isopropyl ether, benzoin isobutyl ether, and benzyl dimethyl ketal.

Examples of triazine compounds include 2,4,6-trichloro-s-triazine, 2-phenyl-4,6-bis(trichloromethyl)-s-triazine, 2-(3',4'-dimethoxystyryl)-4,6-bis(trichloromethyl)-s-triazine, 2-(4'-methoxynaphthyl)-4,6-bis(trichloromethyl)-s-triazine, 2-(p-methoxyphenyl)-4,6-bis(trichloromethyl)-s-triazine, 2-(p-tolyl)-4,6-bis(trichloromethyl)-s-triazine, 2-biphenyl-4,6-bis(trichloromethyl)-s-triazine, bis(trichloromethyl)-6-styryl-s-triazine, 2-(naphth-1-yl)-4,6-bis(trichloromethyl)-s-triazine, 2-(4-methoxynaphth-1-yl)-4,6-bis(trichloromethyl)-s-triazine, 2,4-bis(trichloromethyl)-6-piperonyl-s-triazine, and 2,4-bis(trichloromethyl)-6-(4-methoxystyryl)-s-triazine.

Examples of oxime compounds include 1,2-octanedione, O-acyloxime compounds, 2-(O-benzoyloxime)-1-[4-(phenylthio)phenyl]-1,2-octanedione, 1-(O-acetyloxime)-1-[9-ethyl-6-(2-methylbenzoyl)-9H-carbazol-3-yl]ethanone, and O-ethoxycarbonyl-α-oxyamino-1-phenylpropan-1-one. Specific examples of the O-acyloxime compounds include 2-dimethylamino-2-(4-methylbenzyl)-1-(4-morpholin-4-yl-phenyl)-butan-1-one, 1-(4-phenylsulfanylphenyl)-butane-1,2-dione-2-oxime-O-benzoate, 1-(4-phenylsulfanylphenyl)-octane-1,2-dione-2-oxime-O-benzoate, 1-(4-phenylsulfanylphenyl)-octan-1-one oxime-O-acetate, and 1-(4-phenylsulfanylphenyl)-butan-1-one oxime-O-acetate.

In addition to the above compounds, as the photo-radical generator (B), it is possible to use carbazole compounds, diketone compounds, sulfonium borate compounds, diazo compounds, imidazole compounds, non-imidazole compounds, fluorene compounds, etc.

The photo-radical generator (B) is preferably in the range of 0.1 to 10 mass%, more preferably in the range of 0.5 to 6 mass% relative to the total amount of the photosensitive resin composition. When the photo-radical generator is contained within the above range, balance between sensitivity and developability during exposure is excellent and a pattern with excellent resolution can be obtained without residual film. In addition, one of the photo-radical generators may be used, or two or more kinds thereof may be used in combination.

### [(C) Quantum Dot Having Specific Surface Coating Layer]

A quantum dot is a nano-sized semiconductor substance. Atoms form a molecule, and the molecules constitute a small molecular aggregate called "cluster" to form a nanoparticle. When such a nanoparticle particularly exhibits semiconductor properties, it is called a quantum dot (quantum dot particle).

When a quantum dot is excited by receiving external energy, the quantum dot releases energy (emits light) according to corresponding energy band gap by itself (autonomously) .

(C) the quantum dot used in the present invention is not particularly limited as long as it has a surface coating layer containing siloxane, and can be used in any form. A quantum dot is mainly a nanoparticle of 10 nm or less, may be a nanowire, a nanorod, a nanotube, a nanocube, etc., and any shape can be applied. In the present invention, the average particle diameter of the quantum dot was determined by directly observing at least 20 particles using a transmission electron microscope (TEM), calculating the diameter of a circle having the same area as the projected area of the particle, and using the average value thereof.

The quantum dot (C) used in the present invention can be selected from any suitable materials, for example as semiconductor materials, selected from the group consisting of II-VI group, III-V group, IV group, IV-VI group, I-III-VI group, II-IV-V group, mixed crystals or alloys thereof, and compounds having a perovskite structure. Specific examples thereof include compounds containing ZnS, ZnSe, ZnTe, CdS, CdSe, CdTe, AlN, AlP, AlAs, AlSb, GaN, GaP, GaAs, GaSb, InN, InP, InAs, InSb, Si, Ge, Sn, Pb, PbS, PbSe, PbTe, SnS, SnSe, SnTe, AgGaS₂, AgInS₂, AgGaSe₂, AgInSe₂, CuGaS₂, CuGaSe₂, CuInS₂, CuInSe₂, ZnSiP₂, ZnGeP₂, CdSiP₂, CdGeP₂, CsPbCl₃, CsPbBr₃, CsPbI₃, CsSnCl₃, CsSnBr₃, or CsSnI₃, but not limited thereto.

(C) the quantum dot used in the present invention may have a core-shell structure. Shell materials capable of forming a core-shell structure are not particularly limited, but preferably has a large band gap and low lattice mismatch with respect to the core material, and can be arbitrarily combined according to the core material. Specific examples of the shell material include ZnO, ZnS, ZnSe, ZnTe, CdS, CdSe, CdTe, AlN, AlP, AlAs, AlSb, GaN, GaP, GaAs, GaSb, InN, InP, InAs, InSb, BeS, BeSe, BeTe, MgS, MgSe, MgTe, PbS, PbSe, PbTe, SnS, SnSe, SnTe, CuF, CuCl, CuBr, and CuI. One kind of these materials may be used, or two or more kinds thereof may be used as a mixed crystal made of a plurality of materials, and the materials are not limited thereto.

There are various methods for manufacturing the quantum dot (C) used in the present invention, such as a liquid phase method and a vapor phase method, but in the present invention, the methods are not particularly limited. From the viewpoint of exhibiting high fluorescence emission efficiency, it is preferable to use semiconductor nanoparticles obtained using a hot soap method or a hot injection method, in which a precursor species is reacted at high temperature in a nonpolar solvent having a high boiling point. In order to impart dispersibility in a nonpolar solvent and reduce surface flaws, it is desirable that organic ligands are coordinated on the surface.

The organic ligand preferably has an aliphatic hydrocarbon from the viewpoint of dispersibility. Examples of such an organic ligand include oleic acid, stearic acid, palmitic acid, myristic acid, lauric acid, decanoic acid, octanoic acid, oleylamine, stearyl(octadecyl)amine, dodecyl(lauryl)amine, decylamine, octylamine, octadecanethiol, hexadecanethiol, tetradecanethiol, dodecanethiol, decanethiol, octanethiol, trioctylphosphine, trioctylphosphine oxide, triphenylphosphine, triphenylphosphine oxide, tributylphosphine, and tributylphosphine oxide. One kind of the organic ligands may be used, or two or more kinds thereof may be used in combination.

The quantum dot (C) used in the present invention is coordinated with a ligand having a substituent capable of forming a siloxane bond besides the above-mentioned organic ligand. As the ligand having a substituent capable of forming a siloxane bond, it is desirable to have a substituent that interacts with or adsorbs to the quantum dot surface. The substituents that interact with or adsorb to the quantum dot surface include an amino group, a thiol group, a carboxy group, a mercapto group, a phosphino group, a phosphine group, a phosphine oxide group, a sulfonyl group, an ammonium ion, and a quaternary ammonium salt. Among these, an amino group, a carboxy group, a mercapto group, a phosphine group, and a quaternary ammonium salt are preferable from the viewpoint of coordination strength.

The surface of the quantum dot (C) used in the present invention is coated with siloxane. Therefore, the quantum dot has a substituent that can form a siloxane bond on the ligand having a substituent for the interaction or the absorption on its surface. Examples of the substituents capable of forming a siloxane bond include compounds containing alkoxysilanes, such as a trimethoxysilyl group, a triethoxysilyl group, a dimethoxymethylsilyl group, a diethoxymethylsilyl group, a dimethylmethoxysilyl group, and an ethoxydimethylsilyl group; compounds having a silazane bond; compounds having an Si-OH bond; compounds having an Si-X (X: halogen) bond; and carboxylic acids. It is preferable to use a ligand containing alkoxysilane, silazane, or Si-OH because the reaction can proceed under mild conditions in which no acid is generated as a reaction by-product. A phenyl group-containing siloxane can be formed by reacting these with diphenyldisilanol or the like.

The coating amount of siloxane is not particularly limited, but is preferably in the range of 1 to 50 mass%, more preferably in the range of 5 to 30 mass%. When the coating amount of siloxane is too large, the quantum dot content decreases, but when it is within the above range, it is possible to improve the dispersibility in the base polymer and prevent the deterioration of the quantum dots during exposure.

The quantum dot (C) used in the present invention may further include a skeleton having a (meth)acryloyl group in the surface coating layer.

By introducing the (meth)acryloyl group into the surface coating layer, the (meth)acryloyl group-containing resin (A) and the surface coating layer are crosslinked after exposure, so quantum dots are prevented from escaping during development, and high luminous properties of the pattern can be obtained. In addition, the compatibility with the (meth)acryloyl group-containing resin (A) increases, and it is possible to prevent aggregate formation when used in a photosensitive resin composition.

The amount of the quantum dot (C) to be used in the present invention is preferably 5 to 80 mass%, more preferably 10 to 70 mass% of the total amount of the photosensitive resin composition. When the content of the quantum dot particles is within the above range, it is possible to form a fine pattern while maintaining good luminous properties.

The method and amount of introducing the (meth)acryloyl group into the component (C) are not particularly limited. It is possible to use a method of adding a skeleton having an alkoxysilane-containing (meth)acryloyl group, which was prepared in advance, for reaction, or a method of directly introducing a skeleton having a (meth)acryloyl group by a radical reaction or the like, when the phenyl group-containing siloxane can be formed as described above. The amount to be introduced may be adjusted appropriately, in consideration of compatibility with the resin.

### [(D) Surfactant]

The inventive photosensitive resin composition may further contain a surfactant (D) in order to improve coatability.

Examples of the surfactant include polyoxyethylene alkyl ethers, such as polyoxyethylene lauryl ether, polyoxyethylene sterial ether, polyoxyethylene cetyl ether, and polyoxyethylene olein ether; polyoxyethylene alkyl allyl ethers, such as polyoxyethylene octylphenol ether and polyoxyethylene nonylphenol ether; polyoxyethylene polyoxypropylene block copolymers; sorbitan fatty acid esters, such as sorbitan monolaurate, sorbitan monopalmitate, and sorbitan monostearate; nonionic surfactants of polyoxyethylene sorbitan fatty acid esters, such as polyoxyethylene sorbitan monolaurate, polyoxyethylene sorbitan monopalmitate, polyoxyethylene sorbitan monostearate, polyether silicone, polyoxyethylene sorbitan trioleate, and polyoxyethylene sorbitan tristearate; and fluorine-based surfactant, such as EFTOP EF301, EF303 and EF352 (Tohkem Products Co., Ltd.), Megaface F171, F172 and F173 (DIC Corp.), Fluorad FC-4430, FC-430 and FC-431 (Sumitomo 3M Co., Ltd.), Surfynol E1004 (manufactured by Nissin Chemical Industry Co., Ltd.), Asahiguard AG710, Surflon S-381, S-382, SC101, SC102, SC103, SC104, SC105, SC106, KH-10, KH-20, KH-30 and KH-40 (AGC Seimi Chemical Co., Ltd.); organosiloxane polymers KP-341, X-70-092, and X-70-093 (manufactured by Shin-Etsu Chemical Co., Ltd.), and acrylic acid- or methacrylic acid-based Polyflow No. 75 and No. 95 (manufactured by Kyoeisha Chemical Co., Ltd.).

The surfactant (D) is preferably contained in 0.01 to 3 mass%, more preferably 0.02 to 1 mass%, based on the total amount of the photosensitive resin composition. One kind of these surfactants may be used, or two or more kinds thereof may be used in combination.

### [(E) Silane Coupling Agent]

The inventive photosensitive resin composition may further contain a silane coupling agent (E) in order to improve adhesiveness to a substrate.

Examples of silane coupling agents include amino group-containing silane coupling agents, epoxy group-containing silane coupling agents, (meth)acryloyl group-containing silane coupling agents, mercapto group-containing silane coupling agents, vinyl group-containing silane coupling agents, ureido group-containing silane coupling agents, sulfide group-containing silane coupling agents, and silane coupling agents having a cyclic anhydride structure. Among these, (meth)acryloyl group-containing silane coupling agents are preferable.

Examples of the (meth)acryloyl group-containing silane coupling agent include KBM-502, KBM-503, KBE-502, KBE-503, and KBM-5103 (manufactured by Shin-Etsu Chemical Co., Ltd.).

The amount of the silane coupling agent (E) is contained preferably in 0.01 to 5 mass%, more preferably 0.05 to 4 mass%, based on the total amount of the photosensitive resin composition. One kind of these may be used, or two or more kinds thereof may be used in combination.

### [(F) Crosslinking Agent]

The inventive photosensitive resin composition may further contain a crosslinking agent (F). The crosslinking agent is a component that undergoes a crosslinking reaction with the (meth)acryloyl group-containing resin (A) or the surface coating layer of the quantum dots (C), and makes it easy to form a pattern having a good shape. Therefore, the crosslinking agent preferably has two or more functions of (meth)acryloyl groups.

Examples of the crosslinking agents having two or more functions of (meth)acryloyl groups include polyfunctional monomer, such as ethylene glycol di(meth)acrylate, diethylene glycol di(meth)acrylate, tetraethylene glycol di(meth) acrylate, propylene glycol di(meth)acrylate, polypropylene glycol di(meth)acrylate, butylene glycol di(meth)acrylate, neopentyl glycol di(meth)acrylate, 1,6-hexane glycol di(meth)acrylate, trimethylolpropane tri(meth)acrylate, glycerin di(meth)acrylate, pentaerythritol triacrylate, pentaerythritol tetraacrylate, dipentaerythritol pentaacrylate, dipentaerythritol hexaacrylate, pentaerythritol di(meth)acrylate, pentaerythritol tri(meth) acrylate, pentaerythritol tetra(meth)acrylate, dipentaerythritol penta(meth) acrylate, dipentaerythritol hexa(meth)acrylate, 2,2-bis(4-(meth)acryloxydiethoxyphenyl)propane, 2,2-bis(4-(meth)acryloxypolyethoxyphenyl) propane, 2-hydroxy-3-(meth)acryloyloxypropyl(meth) acrylate, ethylene glycol diglycidyl ether di(meth) acrylate, diethylene glycol diglycidyl ether di(meth)acrylate, phthalic acid diglycidyl ester di(meth) acrylate, glycerin triacrylate, glycerin polyglycidyl ether poly(meth)acrylate, urethane (meth)acrylate (i.e., a reaction product of tolylene diisocyanate, trimethylhexamethylene diisocyanate, or hexamethylene diisocyanate, or the like, with 2-hydroxyethyl (meth)acrylate), methylene bis(meth) acrylamide, (meth)acrylamide methylene ether, and condensation product of polyhydric alcohol and N-methylol (meth)acrylamide; and triacrylformal.

The crosslinking agent (F) is preferably contained in an amount of 0.5 to 100 parts by mass, and more preferably 1 to 50 parts by mass, based on 100 parts by mass of the component (A). One kind of these may be used, or two or more thereof may be used in combination.

### [(G) Solvent]

The inventive photosensitive resin composition may contain a solvent as component (G). The solvent (G) is not particularly limited as long as it can dissolve or disperse the above-mentioned components (A) to (F) and various other additives.

The solvent (G) is preferably an organic solvent. Specific examples thereof include ketones, such as cyclohexanone, cyclopentanone, and methyl-2-n-pentyl ketone; alcohols, such as 3-methoxybutanol, 3-methyl-3-methoxybutanol, 1-methoxy-2-propanol, and 1-ethoxy-2-propanol; ethers, such as propylene glycol monomethyl ether, ethylene glycol monomethyl ether, propylene glycol monoethyl ether, ethylene glycol monoethyl ether, propylene glycol dimethyl ether, and diethylene glycol dimethyl ether; and esters, such as propylene glycol monomethyl ether acetate, propylene glycol monoethyl ether acetate, ethyl lactate, ethyl pyruvate, butyl acetate, methyl 3-methoxypropionate, ethyl 3-ethoxypropionate, tert-butyl acetate, tert-butyl propionate, propylene glycol-mono-tert-butyl ether acetate, and γ-butyrolactone. One kind of these may be used, or two or more thereof may be used in a mixture.

As the solvent (G), propylene glycol monomethyl ether acetate, propylene glycol monomethyl ether, cyclopentanone, and mixed solvents thereof are preferable, which have particularly excellent solubility of the (meth)acryloyl group-containing resin (A) and the photo-radical generator (B).

The component (G) is preferably contained in 25 to 85 mass%, more preferably 35 to 75 mass% of the total amount of the photosensitive resin composition, from the viewpoint of compatibility and viscosity of the photosensitive resin composition.

### [Photosensitive Resin Film]

The inventive photosensitive resin film is a dried product of the photosensitive resin composition described above.

### [Patterning Process Using Photosensitive Resin Composition]

The patterning process using the inventive photosensitive resin composition includes steps of:
(i) applying the photosensitive resin composition described above onto a substrate to form a photosensitive resin film on the substrate;
(ii) exposing the photosensitive resin film to light; and
(iii) developing the exposed photosensitive resin film with a developer.

The step (i) is a step in which the photosensitive resin composition described above is applied onto a substrate to form a photosensitive resin film on the substrate. The photosensitive resin film is a dried product of the photosensitive resin composition described above. Examples of the substrate include a silicon wafer, a glass wafer, a quartz wafer, a plastic circuit substrate, and a ceramic circuit substrate.

The application method may be a publicly known method, and the examples thereof include a dipping method, a spin-coating method, and a roll-coating method. The amount to be applied can be appropriately selected in accordance with the purpose, but the application is performed so that the obtained photosensitive resin film (the dried product of the photosensitive resin composition) has preferably a thickness of 0.1 to 200 µm, more preferably 1 to 150 µm.

In this case, the solvent or the like may be evaporated in advance by pre-heating (pre-baking) as necessary for efficient photocuring reaction. The pre-baking may be performed, for example, at 40 to 140°C for about 1 minute to 1 hour.

Then, (ii) the photosensitive resin film is exposed to light. In this event, the exposure is preferably performed with light having a wavelength of 10 to 600 nm, more preferably performed with light having a wavelength of 190 to 500 nm. The light having such wavelengths are, for example, light having various wavelengths generated from a radiation-beam generating instrument. Examples of the light include ultraviolet light, such as a g-line, an h-line, and an i-line; and far ultraviolet light (248 nm, 193 nm). Among these, light with a wavelength of 248 to 436 nm is particularly preferable. The exposure dose is preferably 10 to 10,000 mJ/cm².

The exposure may be performed via a photomask. The photomask may have a desired pattern by boring, for example. Incidentally, materials of the photomask are not particularly limited, but are preferably those blocks light having the aforementioned wavelength. For example, a photomask containing chromium is suitably used as a light-blocking film, but is not limited thereto.

(iii) the exposed photosensitive resin film is developed with a developer after the exposure to form a pattern. The developers are preferably organic solvents, such as alcohols including IPA; ketones including cyclohexanone; and glycols including propylene glycol monomethyl ether, or publicly known alkaline developers typically represented by an aqueous solution of tetramethylammonium hydroxide or the like. Examples of the development method may be common methods. Examples thereof include a dip method in which a patterned substrate is soaked in a developer, a puddle method in which a developer is dispensed with a paddle, and a spray method in which a developer is sprayed with a spray. By the development according to these methods, an unexposed portion is dissolved and removed, and a pattern is formed. Then, as necessary, washing, rinsing, drying, and so forth are carried out to obtain a cured film having a desired pattern.

The patterning processes using the inventive photosensitive resin composition make it possible to easily form a fine pattern. For example, light in red and green can be also emitted thanks to forming a cured film containing red quantum dots and green quantum dots in each segment on a blue micro-LED by: forming a film by using the inventive photosensitive resin composition so that the film covers numerous blue micro-LEDs paving a substrate; and next performing a fine patterning. Thus, it becomes possible to produce a light emitting device capable of emitting full color.

### [Light Emitting Device]

The inventive light emitting device includes a cured film obtained by the patterning process described above.

### EXAMPLE

Hereinafter, the present invention will be specifically described with reference to Synthesis Examples, Examples, and Comparative Examples. However, the present invention is not limited thereto. Incidentally, a quantum dot of an InP/ZnSe/ZnS core-shell type was used as a quantum dot material. The synthesis methods for the core are as shown below in [1-1] (red quantum dot) and [1-2] (green quantum dot), and the subsequent synthesis method for the shell is as shown in [2].

### [1-1] Synthesis Process of Red Quantum Dot Core

Two flasks were prepared, and 0.23 g (0.9 mmol) of palmitic acid, 0.088 g (0.3 mmol) of indium acetate, and 10 mL of 1-octadecene were added to each flask. The mixture was heated and stirred at 100°C under reduced pressure, and degassed for 1 hour while dissolving the materials. Then, nitrogen was purged into the two flasks, and 0.75 mL (0.15 mmol) of tristrimethylsilylphosphine/trioctylphosphine solution (0.2 M) was added to both flasks. One of the flasks was then heated to 300°C, and the solution was drawn from the flask that had not been heated and added gradually to the flask that had been heated to 300°C, thereby to produce a core particle.

### [1-2] Synthesis Process of Green Quantum Dot Core

0.23 g (0.9 mmol) of palmitic acid, 0.088 g (0.3 mmol) of indium acetate, and 10 mL of 1-octadecene were added to a flask, and the mixture was heated and stirred at 100°C under reduced pressure, and degassed for 1 hour while dissolving the materials. Then, nitrogen was purged into the flask, and 0.75 mL (0.15 mmol) of a solution prepared by mixing tristrimethylsilylphosphine with trioctylphosphine to give a 0.2 M solution was added thereto, and the temperature was raised to 300°C to produce a core particle.

### [2] Synthesis Process of Quantum Dot Shell

Next, 2.85 g (4.5 mmol) of zinc stearate and 15 mL of 1-octadecene were added to another flask, and the mixture was heated and stirred at 100°C under reduced pressure, and degassed for 1 hour while dissolving the zinc stearate, thereby to prepare a 0.3 M zinc stearate octadecene solution. 3.0 mL (0.9 mmol) of the solution was added to the reacted solution having the core synthesized and was cooled to 200°C. Next, 0.474 g (6 mmol) of selenium and 4 mL of trioctylphosphine were added to another flask, and the mixture was heated to 150°C for dissolving, thereby to prepare a 1.5 M selenium trioctylphosphine solution. While heating the reacted solution after the core synthesis process, which had been cooled to 200°C, to 320°C over 30 minutes, the solution was added with the selenium trioctylphosphine solution in 0.1 mL increments to a total of 0.6 mL (0.9 mmol), maintained at 320°C for 10 minutes, and then cooled to room temperature. 0.44 g (2.2 mmol) of zinc acetate was added to the solution and dissolved by heating and stirring at 100°C under reduced pressure. The flask was purged again with nitrogen and heated to 230°C, added with 0.98 mL (4 mmol) of 1-dodecanethiol, and held for 1 hour. The resulting solution was cooled to room temperature to prepare a solution containing core-shell type quantum dots. The red core-shell type quantum dot-containing solution synthesized through the processes from [1-1] to [2] is designated R-1, and the green core-shell type quantum dot-containing solution synthesized through the processes from [1-2] to [2] is designated G-1.

### [3] Process of Replacing Ligand

(3-mercaptopropyl)triethoxysilane was used as a ligand having a substituent capable of forming a siloxane bond and a substituent coordinated to the surface of a quantum dot. For the ligand exchange reaction, (3-mercaptopropyl)triethoxysilane (3.0 mmol) was added to the solution after the shell synthesis process that had been cooled to room temperature, and the solution was stirred for 24 hours. After the reaction was completed, ethanol was added to make precipitate in the reaction solution, which was then centrifuged to remove the supernatant. The same purification process was repeated again, and the resultant was dispersed in toluene to produce a solution of a quantum dot in which ligands having a substituent capable of forming a siloxane bond were coordinated. The quantum dot having the ligand having a substituent capable of forming a siloxane bond synthesized using R-1, was designated R-2, and the quantum dot having the ligand having a substituent capable of forming a siloxane bond synthesized using G-1, was designated G-2.

### [4-1] Process of Forming Surface Coating Layer

Triethoxysilylpropyl methacrylate (4.0 mmol), diphenylsilanediol (6 mmol), barium hydroxide monohydrate (0.15 mmol), and the a quantum dot toluene solution after the process of replacing ligands were added to a flask that had been purged with nitrogen, and the mixture was heated and stirred at 65°C for 24 hours. After the reaction was completed, the mixture was cooled to room temperature; ethanol was added to make precipitate in the reaction solution; the solution was centrifuged; and the supernatant was removed. The precipitate was dispersed in toluene. Then, PGMEA was added thereto, and the toluene solvent was removed by distillation under reduced pressure. Thus, a solution (solution with a solid content of 60%) of a quantum dot having a surface coating layer formed was prepared. The quantum dot in which the surface coating layer was synthesized by using R-2 was designated R-S, and the quantum dot in which the surface coating layer was synthesized by using G-2 was designated G-S.

### [4-2] Process of Forming Surface Coating Layer

Triethoxysilylpropyl methacrylate (4.0 mmol), diphenylsilanediol (6 mmol), barium hydroxide monohydrate (0.15 mmol), and the quantum dot toluene solution after the process of replacing ligands were added to a flask that had been purged with nitrogen, and the mixture was heated and stirred at 65°C for 24 hours. After the reaction was completed, the mixture was cooled to room temperature; ethanol was added to make precipitate in the reaction solution; the solution was centrifuged; and the supernatant was removed. The precipitate was dispersed in toluene and the dispersion was added to a flask that had been purged with nitrogen in advance, and 2 parts by mass of the (meth)acryloyl group-containing resin (A) was added thereto based on 100 parts by mass of the quantum dot toluene solution. Furthermore, 1 part by mass of Irgacure 1173 was added thereto based on 100 parts by mass of the (meth)acryloyl group-containing resin; the mixture was mixed and stirred; and then the mixture was irradiated with light having a wavelength of 365 nm and an output of 4000 mW/cm² for 20 seconds using a UVLED irradiation apparatus. After the reaction was completed, ethanol was added to cause precipitation, and the supernatant after centrifugation was removed and the precipitate was dispersed in toluene again. Then, PGMEA was added thereto, and the toluene solvent was removed by distillation under reduced pressure. Thus, a solution (solution with a solid content of 60%) of a quantum dot having a surface coating layer formed was prepared. In this case, as the (meth)acryloyl group-containing resin (A), the following were used: product name "RA-4101" (Mw: 30,000, acid value: 90 mg KOH/g, double bond equivalent: 350) manufactured by Negami Chemical Industrial Co., Ltd., product name "8KQ-2001" (Mw: 20,000, acid value: 130 mg KOH/g, double bond equivalent: 540) and product name "8KQ-7052" (Mw: 19,000, acid value: 7 mg KOH/g, double bond equivalent: 500) manufactured by Taisei Fine Chemical Co., Ltd. Here, the quantum dots having a surface coating layer formed with a combination of R-2 and RA-4101 are designated as R4101; the quantum dots having a surface coating layer formed with a combination of G-2 and RA-4101 are designated as G4101; the quantum dots having a surface coating layer formed with a combination of R-2 and 8KQ-2001 are designated as R2001; the quantum dots having a surface coating layer formed with a combination of G-2 and 8KQ-2001 are designated as G2001; the quantum dots having a surface coating layer formed with a combination of R-2 and 8KQ-7052 are designated as R7052; and the quantum dots having a surface coating layer formed with a combination of G-2 and 8KQ-7052 are designated as G7052.

### [5] Preparation and Evaluation of Photosensitive Resin Composition

### [Examples 1 to 24 and Comparative Examples 1 to 24]

Each component was blended according to the blending amounts shown in Tables 1 to 4, then the mixture was mixed and stirred at room temperature, and microfiltered through a 1.0 µm glass filter to obtain the photosensitive resin compositions of Examples 1 to 24 and Comparative Examples 1 to 24.

**[Table 1]**

| Component | | | Example | | | | | | | | | | | |
|---|---|---|---|---|---|---|---|---|---|---|---|---|---|---|
| | | | 1 | 2 | 3 | 4 | 5 | 6 | 7 | 8 | 9 | 10 | 11 | 12 |
| A | Resin | RA-4101 | 100 | | | | 100 | | | | 100 | | | |
| | | RA-3631P | | 100 | | | | 100 | | | | 100 | | |
| | | 8KQ-2001 | | | 100 | | | | 100 | | | | 100 | |
| | | 8KQ-7052 | | | | 100 | | | | 100 | | | | 100 |
| B | photo-radical generator | Irgacure 184 | 5 | 5 | | | 10 | 10 | | | 15 | 15 | | |
| | | Irgacure OXE01 | | | 5 | 5 | | | 10 | 10 | | | 15 | 15 |
| C | Quantum dot | R4101 | 15 | | | | 100 | | | | 380 | | | |
| | | R-S | | 15 | | | | 100 | | | | 380 | | |
| | | R2001 | | | 15 | | | | 100 | | | | 380 | |
| | | R7052 | | | | 15 | | | | 100 | | | | 380 |
| D | Surfactant | KP-341 | | | | | 0.5 | 0.5 | 0.5 | 0.5 | 3 | 3 | 3 | 3 |
| E | Silane coupling agent | KBM-503 | | | | | 1 | 1 | 5 | 5 | 20 | 20 | 10 | 10 |
| F | Crosslinking agent | M-940 | | | | | 5 | | 20 | | 30 | | 50 | |
| | | DPCA-20 | | | | | | 5 | | 20 | | 30 | | 50 |
| G | Solvent | PGMEA | 120 | 120 | 120 | 120 | 217 | 217 | 236 | 236 | 548 | 548 | 558 | 558 |

**[Table 2]**

| Component | | | Example | | | | | | | | | | | |
|---|---|---|---|---|---|---|---|---|---|---|---|---|---|---|
| | | | 13 | 14 | 15 | 16 | 17 | 18 | 19 | 20 | 21 | 22 | 23 | 24 |
| A | Resin | RA-4101 | 100 | | | | 100 | | | | 100 | | | |
| | | RA-3631P | | 100 | | | | 100 | | | | 100 | | |
| | | 8KQ-2001 | | | 100 | | | | 100 | | | | 100 | |
| | | 8KQ-7052 | | | | 100 | | | | 100 | | | | 100 |
| B | photo-radical generator | Irgacure 184 | 5 | 5 | | | 10 | 10 | | | 15 | 15 | | |
| | | Irgacure OXE01 | | | 5 | 5 | | | 10 | 10 | | | 15 | 15 |
| C | Quantum dot | G4101 | 15 | | | | 100 | | | | 380 | | | |
| | | G-S | | 15 | | | | 100 | | | | 380 | | |
| | | G2001 | | | 15 | | | | 100 | | | | 380 | |
| | | G7052 | | | | 15 | | | | 100 | | | | 380 |
| D | Surfactant | KP-341 | | | | | 0.5 | 0.5 | 0.5 | 0.5 | 3 | 3 | 3 | 3 |
| E | Silane coupling agent | KBM-503 | | | | | 1 | 1 | 5 | 5 | 20 | 20 | 10 | 10 |
| F | Crosslinking agent | M-940 | | | | | 5 | | 20 | | 30 | | 50 | |
| | | DPCA-20 | | | | | | 5 | | 20 | | 30 | | 50 |
| G | Solvent | PGMEA | 120 | 120 | 120 | 120 | 217 | 217 | 236 | 236 | 548 | 548 | 558 | 558 |

**[Table 3]**

| Component | | | Comparative Example | | | | | | | | | | | |
|---|---|---|---|---|---|---|---|---|---|---|---|---|---|---|
| | | | 1 | 2 | 3 | 4 | 5 | 6 | 7 | 8 | 9 | 10 | 11 | 12 |
| A | Resin | RA-4101 | 100 | | | | 100 | | | | 100 | | | |
| | | RA-3631P | | 100 | | | | 100 | | | | 100 | | |
| | | 8KQ-2001 | | | 100 | | | | 100 | | | | 100 | |
| | | 8KQ-7052 | | | | 100 | | | | 100 | | | | 100 |
| B | photo-radical generator | Irgacure 184 | 5 | 5 | | | 10 | 10 | | | 15 | 15 | | |
| | | Irgacure OXE01 | | | 5 | 5 | | | 10 | 10 | | | 15 | 15 |
| C | Quantum dot | R-1 | 15 | | | | 100 | | | | 380 | | | |
| | | R-2 | | 15 | | | | 100 | | | | 380 | | |
| | | R-3 | | | 15 | | | | 100 | | | | 380 | |
| | | R-4 | | | | 15 | | | | 100 | | | | 380 |
| D | Surfactant | KP-341 | | | | | 0.5 | 0.5 | 0.5 | 0.5 | 3 | 3 | 3 | 3 |
| E | Silane coupling agent | KBM-503 | | | | | 1 | 1 | 5 | 5 | 20 | 20 | 10 | 10 |
| F | Crosslinking agent | M-940 | | | | | 5 | | 20 | | 30 | | 50 | |
| | | DPCA-20 | | | | | | 5 | | 20 | | 30 | | 50 |
| G | Solvent | PGMEA | 120 | 120 | 120 | 120 | 217 | 217 | 236 | 236 | 548 | 548 | 558 | 558 |

**[Table 4]**

| Component | | | Comparative Example | | | | | | | | | | | |
|---|---|---|---|---|---|---|---|---|---|---|---|---|---|---|
| | | | 13 | 14 | 15 | 16 | 17 | 18 | 19 | 20 | 21 | 22 | 23 | 24 |
| A | Resin | RA-4101 | 100 | | | | 100 | | | | 100 | | | |
| | | RA-3631P | | 100 | | | | 100 | | | | 100 | | |
| | | 8KQ-2001 | | | 100 | | | | 100 | | | | 100 | |
| | | 8KQ-7052 | | | | 100 | | | | 100 | | | | 100 |
| B | photo-radical generator | Irgacure 184 | 5 | 5 | | | 10 | 10 | | | 15 | 15 | | |
| | | Irgacure OXE01 | | | 5 | 5 | | | 10 | 10 | | | 15 | 15 |
| C | Quantum dot | G-1 | 15 | | | | 100 | | | | 380 | | | |
| | | G-2 | | 15 | | | | 100 | | | | 380 | | |
| | | G-3 | | | 15 | | | | 100 | | | | 380 | |
| | | G-4 | | | | 15 | | | | 100 | | | | 380 |
| D | Surfactant | KP-341 | | | | | 0.5 | 0.5 | 0.5 | 0.5 | 3 | 3 | 3 | 3 |
| E | Silane coupling agent | KBM-503 | | | | | 1 | 1 | 5 | 5 | 20 | 20 | 10 | 10 |
| F | Crosslinking agent | M-940 | | | | | 5 | | 20 | | 30 | | 50 | |
| | | DPCA-20 | | | | | | 5 | | 20 | | 30 | | 50 |
| G | Solvent | PGMEA | 120 | 120 | 120 | 120 | 217 | 217 | 236 | 236 | 548 | 548 | 558 | 558 |

In Tables 1 to 4, the resins are, in product names: "RA-4101" (Mw: 30,000 g/mol, acid value: 90 mgKOH/g, double bond equivalent: 350 g/mol) and "RA-3631P" (Mw: 18,000 g/mol, acid value: 5 mg KOH/g, double bond equivalent: 250 g/mol), which are manufactured by Negami Kogyo Co., Ltd.; and "8KQ-2001" (Mw: 20,000 g/mol, acid value: 130 mgKOH/g, double bond equivalent: 540 g/mol) and "8KQ-7052" (Mw: 19,000 g/mol, acid value: 7 mgKOH/g, double bond equivalent: 500 g/mol), which are manufactured by Taisei Fine Chemical Co., Ltd.

In Tables 1 to 4, the photo-radical generators are, in product names, "Irgacure 184" (1-hydroxycyclohexyl-phenyl ketone) and "Irgacure OXE01", which are manufactured by BASF.

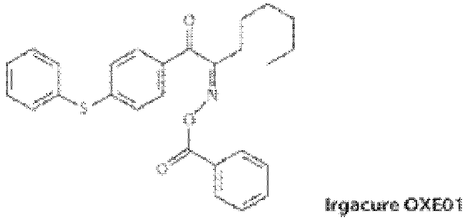

In Tables 1 to 4, the surfactant is, in a product name, "KP-341" (polyether type siloxane) manufactured by Shin-Etsu Chemical Co., Ltd.

In Tables 1 to 4, the silane coupling agent is, in a product name, "KBM-503" (3-methacryloxypropyltrimethoxysilane) manufactured by Shin-Etsu Chemical Co., Ltd.

In Tables 1 to 4, the crosslinking agent is, in a product name, "Aronix (registered trademark) M-940" (dipentaerythritol hexaacrylate) manufactured by Toagosei Co., Ltd., and "DPCA-20" manufactured by Nippon Kayaku Co., Ltd.

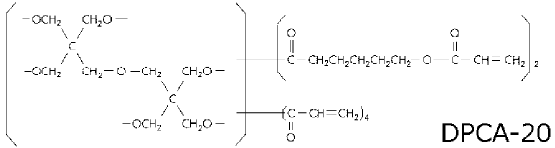

In Tables 1 to 4, for the quantum dots, R-3 is S-BE030 (particle size: 5 to 10 nm, material: InP:ZnS:SeZn = 25:50:25) manufactured by Shoei Chemical Inc.; R-4 is 900514-1ML (particle size: 5 to 10 nm, material: CdSe (core) / CdS (shell) core-shell type) manufactured by Aldrich; G-3 is S-BE029 (particle size: 3 to 5 nm, material: InP:ZnS:SeZn = 25:50:25) manufactured by Shoei Chemical Inc.; and G-4 is 900511-1ML (particle size: 3 to 5 nm, material: CdSe (core) / CdS (shell) core-shell type) manufactured by Aldrich.

### [6] Evaluation of photosensitive resin film

### (1) Checking Presence of Aggregate in Photosensitive Resin Film

A silicon wafer was coated with each of the photosensitive resin composition respectively to form a film having a 10 µm thickness with a spin-coater. In order to remove solvents from the composition, the substrate was heated and dried on a hotplate at 110°C for 2 minutes. A 10 mm × 10 mm area of the obtained photosensitive resin films each was observed to check presence of aggregate in the film with an optical microscope. A sample having an aggregate with a size of 1 µm or more was judged "Bad", and a sample having no aggregate or an aggregate with a size of less than 1 µm was judged "Good". The results are shown in Tables 5 to 8.

### (2) Formation and Evaluation of Pattern Foaming

Using an i-line stepper NSR-2205i11D (manufactured by Nikon Corporation), the obtained photosensitive resin film was exposed to light through a mask to form a square island pattern having a pitch distance of 1:1 to an adjacent pattern. When a sample is for the case that the sequential number of Example or Comparative Example is odd, a pattern was formed after exposure, by paddle development for 60 seconds using 2.38% aqueous solution of tetramethylammonium hydroxide. When a sample is for the case that the sequential number of Example or Comparative Example is even, a pattern was formed after exposure, by paddle development for 60 seconds using PGMEA. Thereafter, the formed island patterns having a side of 50 µm, 30 µm, 20 µm, 10 um, and 5 µm were observed with a scanning electron microscope (SEM), and the size of the smallest pattern that was not connected to the adjacent island pattern (pitch distance 1:1) was defined as limit resolution. When the resolution of a sample did not reach 50 µm or a pattern of a sample was peeled off during development, the sample was judged as "Bad". The results are shown in Tables 5 to 8.

### (3) Evaluation of Luminous Properties of Formed Pattern

Using LabRAM HR Evolution manufactured by Horiba Techno Service Co., Ltd., the patterned sample prepared in (2) above was irradiated with laser beam (0.03 mW) having a wavelength of 457 nm, the photoconverted island pattern area was measured for emission intensity, emission wavelength, and half band width of the photoconverted light. In addition, the sample prepared in (1) above after the heating and drying process was also similarly measured for the emission intensity of the photoconverted light. The results are shown in Tables 5 to 8 ("M" represents 1 million).

### (4) Reliability Test and Evaluation

The patterned measurement sample of (3) above was subjected to a sunlight resistance test for 300 hours at an illuminance of 65 W/m² and at an environmental temperature of 100°C using an Atlas Suntest XLS+ manufactured by Toyo Seiki Seisakusho Co., Ltd. The emission intensity of the photoconverted light were measured before and after the test in the same manner as in (3), and a change rate (rate of decrease) from the initial state was confirmed. The results are shown in Tables 5 to 8. Change rate = ((emission intensity after test/emission intensity before test) - 1) × 100

**[Table 5]**

| | | Example | | | | | | | | | | | |
|---|---|---|---|---|---|---|---|---|---|---|---|---|---|
| | | 1 | 2 | 3 | 4 | 5 | 6 | 7 | 8 | 9 | 10 | 11 | 12 |
| Checking Presence of Aggregate | | Good | Good | Good | Good | Good | Good | Good | Good | Good | Good | Good | Good |
| Limit resolution of patterning / µm | | 5 | 5 | 5 | 5 | 10 | 10 | 10 | 10 | 20 | 20 | 20 | 20 |
| Emission intensity after heating and drying | | 10M | 10M | 10M | 10M | 37M | 37M | 37M | 37M | 55M | 55M | 54M | 54M |
| Luminous properties of pattern in cured film | Wavelength / nm | 622 | 623 | 624 | 623 | 625 | 626 | 625 | 625 | 627 | 628 | 627 | 629 |
| | Half band width / nm | 42 | 41 | 41 | 42 | 43 | 44 | 43 | 43 | 45 | 46 | 45 | 47 |
| | Emission intensity | 10M | 10M | 10M | 10M | 37M | 37M | 37M | 37M | 55M | 55M | 54M | 54M |
| Change in emission intensity after reliability test / % | | -4 | -5 | -5 | -4 | -2 | -2 | -2 | -1 | -2 | -1 | -1 | -2 |

**[Table 6]**

| | | Example | | | | | | | | | | | |
|---|---|---|---|---|---|---|---|---|---|---|---|---|---|
| | | 13 | 14 | 15 | 16 | 17 | 18 | 19 | 20 | 21 | 22 | 23 | 24 |
| Checking Presence of Aggregate | | Good | Good | Good | Good | Good | Good | Good | Good | Good | Good | Good | Good |
| Limit resolution of patterning / µm | | 5 | 5 | 5 | 5 | 10 | 10 | 10 | 10 | 20 | 20 | 20 | 20 |
| Emission intensity after heating and drying | | 8M | 8M | 8M | 8M | 30M | 29M | 29M | 30M | 45M | 45M | 44M | 44M |
| Luminous properties of pattern in cured film | Wavelength / nm | 532 | 534 | 533 | 534 | 536 | 537 | 536 | 537 | 538 | 539 | 539 | 538 |
| | Half band width / nm | 36 | 37 | 37 | 36 | 38 | 39 | 40 | 39 | 41 | 42 | 41 | 42 |
| | Emission intensity | 8M | 8M | 8M | 8M | 30M | 29M | 29M | 30M | 45M | 45M | 44M | 44M |
| Change in emission intensity after reliability test / % | | -5 | -4 | -4 | -5 | -2 | -1 | -2 | -2 | -1 | -1 | -2 | -2 |

**[Table 7]**

| | | Comparative Example | | | | | | | | | | | |
|---|---|---|---|---|---|---|---|---|---|---|---|---|---|
| | | 1 | 2 | 3 | 4 | 5 | 6 | 7 | 8 | 9 | 10 | 11 | 12 |
| Checking Presence of Aggregate | | Bad | Bad | Bad | Bad | Bad | Bad | Bad | Bad | Bad | Bad | Bad | Bad |
| Limit resolution of patterning / µm | | 50 | 50 | 50 | 50 | 50 | 50 | 50 | 50 | Bad | Bad | Bad | Bad |
| Emission intensity after heating and drying | | 5M | 5M | 5M | 5M | 18M | 17M | 17M | 18M | 26M | 27M | 26M | 27M |
| Luminous properties of pattern in cured film | Wavelength / nm | 635 | 636 | 635 | 635 | 637 | 638 | 638 | 636 | 639 | 640 | 641 | 640 |
| | Half band width / nm | 53 | 52 | 52 | 53 | 54 | 55 | 54 | 55 | 56 | 57 | 58 | 57 |
| | Emission intensity | 3M | 3M | 3M | 3M | 12M | 11M | 13M | 12M | 16M | 17M | 16M | 18M |
| Change in emission intensity after reliability test / % | | -58 | -62 | -52 | -55 | -72 | -69 | -76 | -65 | -81 | -90 | -85 | -86 |

**[Table 8]**

| | | Comparative Example | | | | | | | | | | | |
|---|---|---|---|---|---|---|---|---|---|---|---|---|---|
| | | 13 | 14 | 15 | 16 | 17 | 18 | 19 | 20 | 21 | 22 | 23 | 24 |
| Checking Presence of Aggregate | | Bad | Bad | Bad | Bad | Bad | Bad | Bad | Bad | Bad | Bad | Bad | Bad |
| Limit resolution of patterning / µm | | 50 | 50 | 50 | 50 | 50 | 50 | 50 | 50 | Bad | Bad | Bad | Bad |
| Emission intensity after heating and drying | | 4M | 4M | 4M | 4M | 15M | 14M | 14M | 15M | 22M | 23M | 22M | 21M |
| Luminous properties of pattern in cured film | Wavelength / nm | 540 | 541 | 540 | 542 | 544 | 543 | 544 | 545 | 546 | 547 | 546 | 548 |
| | Half band width / nm | 54 | 53 | 53 | 54 | 56 | 57 | 58 | 56 | 59 | 60 | 58 | 59 |
| | Emission intensity | 3M | 3M | 3M | 3M | 11M | 10M | 10M | 1M | 14M | 15M | 15M | 14M |
| Change in emission intensity after reliability test / % | | -57 | -64 | -54 | -58 | -75 | -68 | -75 | -67 | -83 | -91 | -86 | -84 |

From the above results, the inventive photosensitive resin composition was shown to: be able to form a good photosensitive resin film having no aggregate (or having very small aggregates if any); have high lithography resolution, high luminous properties that do not change after the lithography process, and good reliability (low change rate in emission intensity shown in the sunlight resistance test); and be able to provide a cured film suitable for a light emitting device.

The present description includes the following embodiments.
[1]: A photosensitive resin composition comprising:
   (A) a (meth)acryloyl group-containing resin;
   (B) a photo-radical generator; and
   (C) a quantum dot, wherein
   the quantum dot has a surface coating layer containing siloxane.
[2]: The photosensitive resin composition of the above [1], wherein the component (C) has a skeleton having a (meth)acryloyl group in the surface coating layer.
[3]: The photosensitive resin composition of the above [1] or [2], wherein the quantum dot as the component (C) has a ligand coordinated on the surface, the surface coating layer has a siloxane bond bonded to the legend, and a substituent of the ligand has any one or more kinds of an amino group, a thiol group, a carboxy group, a phosphino group, a phosphine oxide group, or an ammonium ion.
[4]: The photosensitive resin composition of the above [1], [2], or [3], wherein the component (C) is contained in 5 to 80 mass% of the photosensitive resin composition.
[5]: The photosensitive resin composition of the above [1], [2], [3], or [4], wherein the component (A) has a double bond equivalent of 240 to 1,000 g/mol.
[6]: The photosensitive resin composition of the above [1], [2], [3], [4], or [5], wherein the component (A) has a weight-average molecular weight of 5,000 to 100,000 g/mol.
[7]: The photosensitive resin composition of the above [1], [2], [3], [4], [5], or [6], further comprising (D) a surfactant.
[8]: The photosensitive resin composition of the above [1], [2], [3], [4], [5], [6], or [7], further comprising (E) a silane coupling agent.
[9]: The photosensitive resin composition of the above [1], [2], [3], [4], [5], [6], [7], or [8], further comprising a crosslinking agent (F) having 2 or more functions of (meth)acryloyl groups.
[10]: The photosensitive resin composition of the above [1], [2], [3], [4], [5], [6], [7], [8], or [9], further comprising (G) a solvent.
[11]: A photosensitive resin film comprising a dried product of the photosensitive resin composition of the above [1], [2], [3], [4], [5], [6], [7], [8], [9], or [10].
[12]: A patterning process comprising steps of:
   (i) applying the photosensitive resin composition of the above [1], [2], [3], [4], [5], [6], [7], [8], [9], or [10] onto a substrate to form a photosensitive resin film on the substrate;
   (ii) exposing the photosensitive resin film to light; and
   (iii) developing the exposed photosensitive resin film with a developer to dissolve and remove an unexposed portion, thereby to form a pattern.
[13]: A light emitting device comprising a cured film obtained by the patterning process of the above [12].

It should be noted that the present invention is not limited to the above-described embodiments. The embodiments are just examples, and any examples that have substantially the same feature and demonstrate the same functions and effects as those in the technical concept disclosed in claims of the present invention are included in the technical scope of the present invention.

## Claims

1. A photosensitive resin composition comprising:
(A) a (meth)acryloyl group-containing resin;
(B) a photo-radical generator; and
(C) a quantum dot, wherein
the quantum dot has a surface coating layer containing siloxane.

2. The photosensitive resin composition according to claim 1, wherein the component (C) has a skeleton having a (meth)acryloyl group in the surface coating layer.

3. The photosensitive resin composition according to claim 1, wherein the quantum dot as the component (C) has a ligand coordinated on the surface, the surface coating layer has a siloxane bond bonded to the legend, and a substituent of the ligand has any one or more kinds of an amino group, a thiol group, a carboxy group, a phosphino group, a phosphine oxide group, or an ammonium ion.

4. The photosensitive resin composition according to claim 1, wherein the component (C) is contained in 5 to 80 mass% of the photosensitive resin composition.

5. The photosensitive resin composition according to claim 1, wherein the component (A) has a double bond equivalent of 240 to 1,000 g/mol.

6. The photosensitive resin composition according to claim 1, wherein the component (A) has a weight-average molecular weight of 5,000 to 100,000 g/mol.

7. The photosensitive resin composition according to claim 1, further comprising (D) a surfactant.

8. The photosensitive resin composition according to claim 1, further comprising (E) a silane coupling agent.

9. The photosensitive resin composition according to claim 1, further comprising a crosslinking agent (F) having 2 or more functions of (meth)acryloyl groups.

10. The photosensitive resin composition according to claim 1, further comprising (G) a solvent.

11. A photosensitive resin film comprising a dried product of the photosensitive resin composition according to any one of claims 1 to 10.

12. A patterning process comprising steps of:
(i) applying the photosensitive resin composition according to any one of claims 1 to 10 onto a substrate to form a photosensitive resin film on the substrate;
(ii) exposing the photosensitive resin film to light; and
(iii) developing the exposed photosensitive resin film with a developer to dissolve and remove an unexposed portion, thereby to form a pattern.

13. A light emitting device comprising a cured film obtained by the patterning process according to claim 12.
